# EUROPÄISCHE PATENTSCHRIFT

(11) **EP 2 146 423 B1**
(45) Veröffentlichungstag und Bekanntmachung des Hinweises auf die Patenterteilung: **09.09.2015**
(21) Anmeldenummer: 09008703.2
(22) Anmeldetag: 03.07.2009
(51) Int. Cl.: H02M 1/08, H02M 3/335

(54) **Verfahren zum Betreiben eines Treibers für einen leistungselektronischen Schalter**
Method for operating a driver for a power electronics switch
Procédé de fonctionnement d'un pilote pour un commutateur électronique de puissance

(30) Priorität: 17.07.2008 DE 102008040515
(43) Veröffentlichungstag der Anmeldung: 20.01.2010
(73) Patentinhaber: Semikron Elektronik GmbH & Co. KG Patentabteilung, 90431 Nürnberg (DE)
(72) Erfinder: Königsmann, Günter, 91058 Erlangen-Tennenlohe (DE); Hofmair, Markus, 91154 Roth (DE); Mühlhofer, Alexander, 90522 Oberasbach (DE); Bode, Rüdiger, 90763 Fürth (DE)

(56) Entgegenhaltungen:
- EP-A1- 1 988 633
- US-A- 3 863 133
- US-A- 5 900 683

## Beschreibung

Die Erfindung betrifft ein Verfahren zum Betreiben eines Treibers, wobei der Treiber ein solcher zum Bedienen eines leistungselektronischen Schalters ist.

Leistungselektronische Schalter in Form von Halbleiterschaltern, wie z.B. IGBTs oder MOSFETs, benötigen zur Durchführung des eigentlichen Schaltvorgangs eine Ansteuerung an ihrem Schalteingang, z.B. dem Gate, durch einen Ausgang einer Treiberschaltung, kurz Treiber genannt. Ein derartiger Treiber wird wiederum an seinem Eingang durch ein logisches Schaltsignal angesteuert. Das logische Schaltsignal liegt hierbei in der Regel auf Anlagenpotential, der Schalter bzw. dessen Schalteingang z.B. auf einem z.T. schwankenden Hochspannungspotential.

Ein Treiber weist daher eine der Schaltungslogik zugewandte Primär- und eine von dieser potentialgetrennte, dem Schalter zugewandte Sekundärseite auf. Die Spannungsversorgung der Sekundärseite erfolgt in einem derartigen Treiber durch einen Leistungsübertrager, der Leistung von der Primär- zur Sekundärseite überträgt und so auf der Sekundärseite eine Versorgungsspannung bereitstellt. Bekannt ist in einem derartigen Treiber die Übertragung von maximal zwei Signalen - meist über die selbe Übertragungsstrecke - für die Kommunikation zwischen Primär- und Sekundärseite. Übertragen wird ein Schaltsignal von der Primär- zur Sekundärseite und ein Fehlersignal von der Sekundär- zur Primärseite. Das Schaltsignal bewirkt ein Ein- oder Ausschalten des Halbleiterschalters, das Fehlersignal erlaubt Rückmeldungen z.B. über den aktuellen Schaltzustand. Bekannt ist, zwischen Primär- und Sekundärseite hierzu Impulsübertrager oder Optokoppler zur Informationsübertragung anzuordnen, welche eine Kommunikation zwischen Primär- und Sekundärseite erlauben.

In höherentwickelten Treibern ist auf der Sekundärseite zusätzlich eine Unterspannungsüberwachung vorgesehen. Diese überprüft ständig die Höhe der auf der Sekundärseite zur Verfügung stehenden Versorgungsspannung und erzeugt ein Ausschaltsignal für den Schalter, wenn die Versorgungsspannung unter einen kritischen Wert fällt. In Treibern ist es außerdem bekannt, einen weiteren Signalweg vorzusehen, um Analogwerte von der Sekundär- zur Primärseite zu übertragen. Außerdem kann in Treibern eine Rückmeldung überwacht werden, welche von der Sekundär- zur Primärseite gesendet wird, und welche Auskunft darüber gibt, ob die Sekundärseite ein Schaltsignal von der Primärseite empfangen hat. Wird also auf der Primärseite ein Schaltsignal erzeugt, welches fehlerhafterweise die Sekundärseite nicht erreicht, so erfolgt keine Rückmeldung in Form eines Rücksignals und somit kann von der Primärseite erkannt werden, dass der Schaltvorgang eventuell nicht erfolgreich war.

Die bekannten Treiber haben folgende Nachteile:
- Bei einem kompletten Ausfall der Signalübertragungsstrecke zwischen Primär- und Sekundärseite, z.B. durch einen Drahtbruch in einem Impulsübertrager, ist es nicht mehr möglich, einen bereits eingeschalteten Halbleiterschalter durch einen Schaltbefehl von der Primärseite aus auszuschalten.
- Für den Fall, dass die Spannungsversorgung der Sekundärseite ausfällt, z.B. durch einen Drahtbruch im Leistungsübertrager oder durch Ausfall des den Treiber versorgenden Netzteils, kann dies durch die sekundärseitige Unterspannungsüberwachung erst bei merklichem Spannungsabfall erkannt werden. Ist der Schalter in diesem Moment eingeschaltet, muss eine Notabschaltung erfolgen. Allerdings ist zu diesem Zeitpunkt die Versorgungsspannung auf der Sekundärseite bereits gesunken. In einem derartigen Fall wird die Sekundärseite wegen der sinkenden Versorgungsspannung, die als Referenzspannung dient, allerdings besonders störempfindlich gegenüber Ein- und Ausschaltimpulsen. Im ungünstigsten Fall kann dies zu einem nur teilweisen Einschalten eines IGBT führen. Den IGBT dann mit der restlich verbleibenden Versorgungsspannung abzuschalten, ist nicht immer zuverlässig möglich.
- Wird ein von der Primärseite ausgesendetes Ausschaltsignal von der Sekundärseite nicht empfangen, ist zwar die Detektion dieses Fehlers möglich, bei der herkömmlichen Impulsübertragertechnik ist es aber nicht mehr möglich, ein zweites Ausschaltsignal zu senden. Dies ist im Aufbau der bekannten Schaltsignalübertragung begründet.

Aus der US 5,900,683 und in ähnlicher Weise aus der EP 1 988 633 A1 ist ein Treiber für ein Leistungsmodul mit verschiedenen integrierten Diagnosemethoden bekannt. Diese dienen der Überwachung von Frequenz, Pulsweite und Amplitude des als Wechselspannung über einen Übertrager gesendeten Schaltsignals.

Aufgabe der vorliegenden Erfindung ist es, ein verbessertes Verfahren zum Betreiben eines Treibers für einen leistungselektronischen Schalter anzugeben.

Die Aufgabe wird gelöst durch ein Betriebsverfahren für einen Treiber, wobei der Treiber ein solcher für einen leistungselektronischen Schalter ist. Der Treiber weist hierbei eine Primär- und eine Sekundärseite auf, wobei zwischen beiden ein Schaltnetzteil angeordnet ist. Das Schaltnetzteil ist mit einem Schalttakt betreibbar und dient zur Leistungsversorgung der Sekundärseite, indem es auf der Sekundärseite eine Versorgungsspannung erzeugt. Der Schalttakt ist hierbei gleichförmig, mit anderen Worten kann diesem eine konstante Schaltfrequenz bzw. Arbeitsfrequenz, z.B. 10kHz, zugeordnet werden.

Gemäß der Erfindung wird auf der Sekundärseite der Schalttakt des Schaltnetzteils aus der von ihm gelieferten Versorgungsspannung ermittelt. Auf der Sekundärseite wird der Schalttakt bezüglich einer Sollfrequenz überwacht, wobei ein Ausschaltbefehl für den leistungselektronischen Schalter dann erzeugt wird, wenn der ermittelte Schalttakt - zumindest über übliche Toleranzgrenzen hinaus - von der Sollfrequenz abweicht.

Das erfindungsgemäße Betriebsverfahren hat den Vorteil, dass bei Ausfall der Primärseite - z.B. Ausfall der Versorgungsspannung auf der Primärseite, Störung des Leistungsübertragers zwischen Primär- und Sekundärseite oder ähnlichem - bei welchem sich der Schalttakt des Schaltnetzteils über die üblichen Toleranzgrenzen hinweg verändert, dies sofort von der Sekundärseite erkannt wird, und ein Ausschaltbefehl für den leistungselektronischen Schalter erzeugt wird. All dies geschieht, noch bevor die sekundärseitige Betriebs- bzw. Versorgungsspannung bezüglich ihrer Höhe nennenswert einbricht. In einem in der Regel vorhandenen Energiespeicher der Sekundärseite steht damit immer noch genügend Spannung bzw. Ladung zur Verfügung, um den angeschlossenen leistungselektronischen Schalter, z.B. einen IGBT, sicher und zuverlässig auszuschalten. Das erfindungsgemäße Verfahren ist damit der bekannten Unterspannungsüberwachung deutlich überlegen.

Eine vorteilhafte Ausgestaltung der Erfindung gilt für Treiber, deren Sekundärseite einen programmierbaren Logikbaustein, z.B. einen Microcontroller oder ein FPGA enthält. Derartige Logikbausteine verwalten mannigfaltige Funktionen auf der Sekundärseite und sind heute Standard in vielen digitalen Treibern. In diesem Fall kann der Logikbaustein den Schalttakt z.B. direkt aus der Versorgungsspannung ermitteln. Ein entsprechender Logikbaustein in einem bereits bestehenden Treiber besitzt in der Regel genügend ungenutzte Kapazitäten bzw. Reserven bezüglich Rechenleistung etc., um diese einfache Aufgabe ohne weitere Modifikationen mit übernehmen zu können. In einer vorteilhaften Variante des Verfahrens ermittelt der Logikbaustein den Schalttakt anhand eines geeigneten Spannungsteilers aus der Versorgungsspannung.

Das erfindungsgemäße Verfahren kann so durch einfache Modifikation eines bereits bestehenden Treibers realisiert werden. Der Treiber wird z.B. um einen Spannungsteiler mit Schutzbeschaltung - wie einen Kondensator - als Detektor erweitert, der ein Ausmessen des Schalttaktes des Netzteils erlaubt. Ein Detektor für den Schalttakt kann dann z.B. einfach in Form einer Software bzw. Firmware im Logikbaustein realisiert werden.

Wie bereits erwähnt, besitzen die bekannten Treiber einen Übertragungsweg für ein Ausschaltsignal von der Primär- zur Sekundärseite. Dieser wird im folgenden erster Übertragungsweg genannt und enthält als ersten Signalübertrager, den oben erwähnten Optokoppler oder Impulsübertrager. Der erste Übertragungsweg dient hier in der Regel auch zur Übermittlung eines Einschaltsignals. Gemäß der Erfindung wird durch eine gezielte Störung des Schalttaktes auf der Primärseite das Schaltnetzteil und ein über dieses laufender Signalpfad als zweiter Übertragungsweg für ein Ausschaltsignal genutzt. Somit ergibt sich ein redundanter Weg für ein Ausschaltsignal von der Primär- zur Sekundärseite, um den Leistungshalbleiter gezielt abzuschalten. Dieser Übtragungsweg kann z.B. genutzt werden, wenn der erste Übertragungsweg ausfällt. Der zweite Übertragungsweg ist unabhängig von dem eigentlich für die Schaltsignalübertragung vorgesehenen Kanal. Mit anderen Worten wird ein Ausschaltbefehl durch eine gezielte, gewollte kurzfristige Unterbrechung des Schalttaktes des Netzteils von der Primärseite aus erzeugt. Das Verfahrens beruht auf der Erkenntnis, dass zwischen Primär- und Sekundärseite neben dem o.g. bekannten Abschaltweg ein zweiter, zuverlässiger Übertragungsweg für ein Ausschaltsignal von der Primär- zur Sekundärseite etabliert wird.

Insbesondere kann, um die in der Regel z.B. durch Kondensatoren gepufferte Versorgungsspannung auf der Sekundärseite bezüglich ihrer Höhe nicht zu beeinflussen, diese also nicht zu unterbrechen, in einer bevorzugten Ausführungsform zur Übertragung des Schaltsignals der Schalttakt auf dem zweiten Übertragungsweg nur so kurzzeitig gestört werden, dass eine nicht mehr tolerierbare Abweichung des Schalttaktes von der Sollfrequenz auf der Sekundärseite detektiert wird. Auf der Sekundärseite sind entsprechende Toleranzen für den Schalttakt bekannt, um noch der Sollfrequenz zu entsprechen. Durch eine entsprechende gezielte Überschreitung dieser Toleranzgrenzen wird daher auf der Sekundärseite der Ausschaltbefehl erzeugt.

In einer weiteren vorteilhaften Ausführungsform des Verfahrens weist die Sekundärseite einen Arbeitstakt auf. Dieser ist z.B. der Arbeitstakt eines auf der Sekundärseite angeordneten Microcontrollers. Da gemäß dem erfindungsgemäßen Verfahren der Schalttakt des Schaltnetzteils sekundärseitig aus der Versorgungsspannung ermittelt wird, ist dieser auf der Sekundärseite bekannt. Gemäß einer vorteilhaften Ausführungsform des Verfahrens wird dann der Arbeitstakt der Sekundärseite auf den Schalttakt des Schaltnetzteils synchronisiert. So ist es möglich, lediglich auf der Primärseite einen quarzgenauen Schalttakt für das Schaltnetzteil zu erzeugen. Auf der Sekundärseite genügt dann ein kostengünstiger, durchstimmbarer Taktgenerator, der zwar toleranzbehaftet ist, sich aber auf den hochgenauen Schalttakt der Primärseite synchronisieren lässt. Somit verfügt auch die Sekundärseite über den quarzgenauen Takt der Primärseite ohne hierfür zusätzliche Kosten zu verursachen. Ein quarzgenauer Arbeitstakt steht dann auch auf der Sekundärseite für beliebige weitere Aufgaben zur Verfügung, z.B. eine Frequenzzählung auf der Sekundärseite.

Für eine weitere Beschreibung der Erfindung wird auf die Ausführungsbeispiele der Zeichnung verwiesen. Es zeigt, in einer schematischen Prinzipskizze:

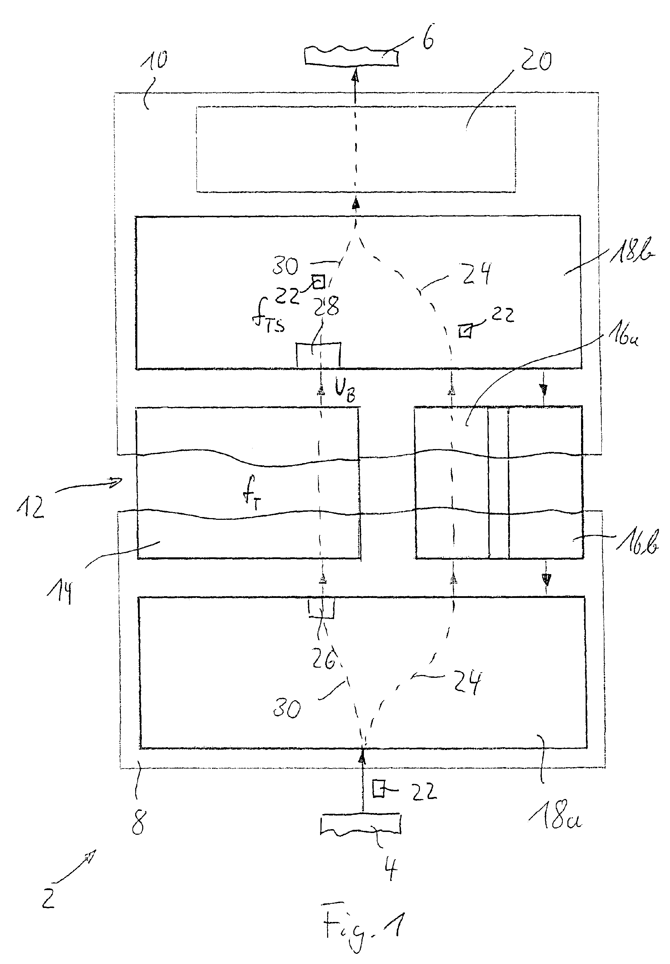

Fig. 1 einen Treiber, der mit dem erfindungsgemäßen Verfahren betrieben wird.

Fig. 1 zeigt einen Treiber 2, welcher zwischen eine Steuerlogik 4 und einen von dieser zu steuernden IGBT 6 geschaltet ist. Der Treiber umfasst eine der Steuerlogik 4 zugewandte Primärseite 8 und eine von dieser galvanisch getrennte, dem IGBT 6 zugewandte Sekundärseite 10. Die galvanische Trennung ist durch den Bereich 12 angedeutet.

Die galvanische Trennung wird durch Primärseite 8 und Sekundärseite 10 verbindende Bauteile des Treibers 2 überbrückt. Diese sind ein als Schaltnetzteil ausgebildetes zentrales Netzteil 14 sowie Signalübertrager 16a und 16b. Der Treiber 2 enthält außerdem primär- und sekundärseitig je eine Logik 18a,b und eine sekundärseitige Endstufe 20.

Im regulären Betrieb überträgt das Netzteil 14 zur Leistungsversorgung der Sekundärseite 10 eine auf der Primärseite 8 bereitgestellte elektrische Leistung in Form einer Versorgungsspannung U_{B} auf die Sekundärseite 10. Das Netzteil 14 ist ein Schaltnetzteil und arbeitet hierbei mit dem Schalttakt der Frequenz f_{T}.

Fig. 1 zeigt eine Situation, in der der IGBT 6 zunächst eingeschaltet ist. Ein fehlerfreier Ausschaltvorgang geht folgendermaßen vor sich: Zum Ausschalten erzeugt die Steuerlogik 4 ein Ausschaltsignal 22, welches sie an die Logik 18a übermittelt. Die Logik 18a leitet das Ausschaltsignal 22 zum Signalübertrager 16a, welcher dieses über die Potentialgrenze der Linie 12 hinweg zur Logik 18b weiterleitet. Die Logik 18b steuert hierauf die Endstufe 20 an, welche den IGBT 6 ausschaltet. Somit ergibt sich ein durch die Linie 24 dargestellter erster Ausschaltpfad für den IGBT 6. Das Ausschaltsignal 22 ist hierbei ein kontinuierliches Signal.

Die Logik 18b meldet das erfolgreiche Empfangen des Ausschaltsignals 22 über den Signalübertrager 16b zurück an die Logik 18a. Diese erkennt daran, dass das Ausschaltsignal 22 erfolgreich empfangen wurde.

Im vorliegenden Fall erfolgt diese Rückmeldung aufgrund eines Fehlers in der oben erläuterten Ereigniskette nicht. Die Logik 18a ist damit nicht sicher, ob nun das Ausschaltsignal 22 tatsächlich übertragen, der IGBT 6 korrekt abgeschaltet wurde und nur die Quittierung über den Signalübertrager 16b fehlerhafterweise nicht anliegt oder ob das Ausschaltsignal 22 die Logik 18b nicht erreicht hat und daher der IGBT 6 noch eingeschaltet ist.

Die Logik 18a greift daher zum erfindungsgemäßen Verfahren: Sie schaltet über einen Ausgang 26 das Netzteil 14 kurzzeitig ab. Das Netzteil 14 verliert daher seinen Schalttakt der Frequenz f_{T}. Insbesondere wertet die Logik 18b über eine Auswerteelektronik 28, z.B. den in der Fig. gezeigten Spannungsteiler, die Versorgungsspannung U_{B} hinsichtlich der Frequenz f_{T} aus und detektiert deren Ausfall bzw. die - wenn auch kurzfristige - Abweichung von einer in der Logik 18b hinterlegten Sollfrequenz f_{TS}. Da die Frequenz f_{T} mehr als im Rahmen eines Toleranzbereiches um die Sollfrequenz f_{TS} absinkt, gibt die Logik 18b den Ausschaltbefehl 22 an die Endstufe 20 weiter, welche daraufhin den IGBT 6 abschaltete. Dies ist dann noch ohne weiteres möglich, da zwar in der Versorgungsspannung U_{B} der Schalttakt der Frequenz f_{T} nicht mehr durch die Auswerteelektronik 28 messbar ist, die Versorgungsspannung U_{B} ihrem Betrag nach jedoch noch nicht wesentlich eingebrochen ist und in nahezu voller Höhe zur Verfügung steht.

Durch das Unterbrechen der Frequenz f_{T} entsteht somit ein zweiter Ausschaltweg für den IGBT 6, angedeutet durch die Linie 30, welcher zum ersten Ausschaltweg, also der Linie 24 unterschiedlich ist.

Der zweite Ausschaltweg entlang der Linie 30 bewirkt außerdem noch einen zusätzlichen Sicherungsmechanismus für den Treiber 2. Zu einem anderen Betriebszeitpunkt des Treibers 2 fällt nämlich ein nicht dargestelltes Netzteil aus, das seinerseits den Treiber 2 mit Leistung versorgt. Der IGBT 6 ist eingeschaltet, ein Ausschaltsignal 22 wurde von der Steuerlogik 4 nicht abgesetzt. Trotz Ausfall des Schalttaktes ist zu diesem Zeitpunkt die Versorgungsspannung UB noch nicht eingebrochen, da nicht dargestellte Pufferkondensatoren auf der Sekundärseite 10 noch voll geladen sind und die Versorgungsspannung U_{B} in voller Höhe noch für eine Restlaufzeit zur Verfügung stellen.

Ein Teil des zweiten Ausschaltweges entlang der Linie 30, nämlich vom Netzteil 14 bis zum IGBT 6 wird nun aktiviert. Alleine das Einbrechen des Schalttaktes der Frequenz f_{T} im Netzteil 14 aufgrund des Ausfalls der Energieversorgung wird wieder von der Auswerteelektronik 28 bzw. der Logik 18b detektiert. Daraufhin wird der IGBT 6 wie oben erläutert anhand eines Ausschaltbefehls 22 abgeschaltet. Ein derartiges Einbrechen der Frequenz f_{T} kann auch andere Ursachen haben, z.B. Störung im Netzteil 14 selbst.

Durch diese Maßnahme wird also der IGBT 6 bei noch nahezu vollständig vorhandener Versorgungsspannung U_{B} sicherheitsabgeschaltet, ohne dass ein Ausschaltbefehl 22 abgesetzt wurde.

In der Logik 18b ist außerdem ein kostengünstiger Oszillator vorhanden, dessen Arbeitstakt f_{A} durchstimmbar ist. Dieser wird auf den quartzgenauen Schalttakt f_{T} des Netzteils 14 synchronisiert. Somit ist die Quartzgenauigkeit auch für den Arbeitstakt f_{A} verfügbar.

## Patentansprüche

1. Verfahren zum Betreiben eines Treibers (2) für einen leistungselektronischen Schalter (6), wobei der Treiber (2) ein zwischen seiner Primär- (8) und Sekundärseite (10) angeordnetes mit einem Schalttakt (f_{T}) betreibbares Schaltnetzteil (14) zur Leistungsversorgung der Sekundärseite (10) mit einer Versorgungsspannung (U_{B}) aufweist, **dadurch gekennzeichnet, dass** der Treiber (2) einen ersten Übertragungsweg (24) für ein Ausschaltsignal (22) mit einem Optokoppler oder Impulsübertrager (16a) zwischen Primär-(8) und Sekundärseite (10) aufweist, bei dem:
- auf der Sekundärseite (10) der Schalttakt (f_{T}) aus der Versorgungsspannung (U_{B}) ermittelt wird,
- auf der Sekundärseite (10) bei Abweichung des Schalttaktes f_{T}) von einer Sollfrequenz (f_{TS}) ein Ausschaltbefehl (22) für den Schalter (6) erzeugt wird,
- durch eine gezielte Störung des Schalttaktes (f_{T}) auf der Primärseite (8) das Schaltnetzteil (14) und ein über dieses laufender Signalpfad als zweiter Übertragungsweg (30), für ein Ausschaltsignal von der Primär- zur Sekundärseite (8,10) um den Schalter (6) gezielt abzuschalten, genutzt wird.

2. Verfahren nach Anspruch 1, wobei die Sekundärseite (10) einen diese verwaltenden programmierbaren Logikbaustein (18b) enthält, bei dem der programmierbare Logikbaustein (18b) den Schalttakt (f_{T}) aus der Versorgungsspannung (U_{B}) ermittelt.

3. Verfahren nach Anspruch 2, wobei der programmierbare Logikbaustein (18b) den Schalttakt (f_{T}) aus der Versorgungsspannung (U_{B}) anhand eines Spannungsteilers (28) ermittelt.

4. Verfahren nach einem der vorhergehenden Ansprüche, bei dem: - der Schalttakt (f_{T}) zur Übertragung eines Schaltsignals (22) auf dem zweiten Übertragungsweg (30) nur so kurzzeitig gestört wird, dass die Abweichung von der Sollfrequenz (f_{TS}) auf der Sekundärseite (10) detektiert wird.

5. Verfahren nach einem der vorhergehenden Ansprüche, wobei die Sekundärseite (10) einen Arbeitstakt (f_{A}) aufweist, bei dem der Arbeitstakt (f_{A}) auf den Schalttakt (f_{T}) synchronisiert wird.

## Claims

1. Method for operating a driver (2) for a power electronic switch (6), wherein the driver (2) has a switched-mode power supply (14) arranged between its primary side (8) and secondary side (10) and operable with a switching clock signal (f_{T}) and serving for the power supply of the secondary side (10) with a supply voltage (U_{B}),
**characterized in that** the driver (2) has a first transmission path (24) for a switch-off signal (22) with an optocoupler or pulse transmitter (16a) between primary side (8) and secondary side (10) wherein:
- on the secondary side (10) the switching clock signal (f_{T}) is determined from the supply voltage (U_{B}),
- on the secondary side (10), a switch-off command (22) for the switch (6) is generated in the case of a deviation of the switching clock signal (f_{T}) from a desired frequency (f_{TS}),
- as a result of a targeted disturbance of the switching clock signal (f_{T}) on the primary side (8), the switched-mode power supply (14) and a signal path running via the latter are used as second transmission path (30), for a switch-off signal from the primary to the secondary side (8, 10) in order to switch off the switch (6) in a targeted manner.

2. Method according to Claim 1, wherein the secondary side (10) contains a programmable logic component (18b) that manages said secondary side, wherein the programmable logic component (18b) determines the switching clock signal (f_{T}) from the supply voltage (U_{B}).

3. Method according to Claim 2, wherein the programmable logic component (18b) determines the switching clock signal (f_{T}) from the supply voltage (U_{B}) with the aid of a voltage divider (28).

4. Method according to any of the preceding claims, wherein:
- the switching clock signal (f_{T}) for transmitting a switching signal (22) on the second transmission path (30) is disturbed only so briefly that the deviation from the desired frequency (f_{TS}) is detected on the secondary side (10).

5. Method according to any of the preceding claims, wherein
the secondary side (10) has an operating clock signal (f_{A}), wherein the operating clock signal (f_{A}) is synchronized with the switching clock signal (f_{T}).

## Revendications

1. Procédé pour faire fonctionner un circuit d'attaque (2) pour un commutateur électronique de puissance (6), dans lequel le circuit d'attaque (2) présente un bloc d'alimentation de commutation (14), pouvant fonctionner avec une cadence de commutation (f_{T}), disposé entre son côté primaire (8) et son côté secondaire (10) pour l'alimentation en puissance du côté secondaire (10) avec une tension d'alimentation (U_{B}),
**caractérisé en ce que** le circuit d'attaque (2) présente un premier trajet de transmission (24) pour un signal de mise hors circuit (22) avec un optocoupleur ou un transformateur d'impulsions (16a) entre le côté primaire (8) et le côté secondaire (10), avec lequel :
- sur le côté secondaire (10), la cadence de commutation (f_{T}) est déterminée d'après la tension d'alimentation (U_{B}),
- sur le côté secondaire (10), en cas d'écart de la cadence de commutation (f_{T}) par rapport à une fréquence théorique (f_{TS}), une instruction de mise hors circuit (22) est générée pour le commutateur (6),
- grâce à une perturbation ciblée de la cadence de commutation (f_{T}) du côté primaire (8), le bloc d'alimentation de commutation (14), et un chemin de signal passant par celui-ci, sont utilisés en tant que deuxième trajet de transmission (30) pour un signal de mise hors circuit allant du côté primaire vers le côté secondaire (8, 10) afin de mettre le commutateur (6) hors circuit de manière ciblée.

2. Procédé selon la revendication 1, dans lequel le côté secondaire (10) comprend un composant logique programmable (18b) assurant la gestion de celui-ci, avec lequel le composant logique programmable (18b) détermine la cadence de commutation (f_{T}) d'après la tension d'alimentation (U_{B}).

3. Procédé selon la revendication 2, dans lequel le composant logique programmable (18b) détermine la cadence de commutation (f_{T}) d'après la tension d'alimentation (U_{B}) à l'aide d'un diviseur de tension (28).

4. Procédé selon l'une des revendications précédentes, avec lequel :
- la cadence de commutation (f_{T}) pour la transmission d'un signal de commutation (22) sur le deuxième trajet de transmission (30) est seulement perturbée temporairement de manière à ce que l'écart par rapport à la fréquence théorique (f_{TS}) soit détecté du côté secondaire (10).

5. Procédé selon l'une des revendications précédentes, dans lequel le côté secondaire (10) présente une cadence de travail (f_{A}), avec lequel procédé la cadence de travail (f_{A}) est synchronisée avec la cadence de commutation (f_{T}).
